# EUROPEAN PATENT APPLICATION

(11) **EP 2 056 362 A2**
(43) Date of publication of application: **06.05.2009**
(21) Application number: 08018765.1
(22) Date of filing: 28.10.2008
(51) Int. Cl.: H01L 31/072, H01L 31/0304

(54) **Multi-junction multi-spectral solar converter**

(30) Priority: 29.10.2007 US 976783
(71) Applicant: Waffenschmidt, Lynn, 76437 Rasta TT (DE)
(72) Inventor: The designation of the inventor has not yet been filed

(57) **Abstract**

This disclosure describes a multi-junction, multi-spectral solar converter and methods of its manufacture for converting solar energy into electricity. Processed on GaP, AlAs, InGaAsN, InGaP, GaAs, Ge, Si, diamond, or any substrates sensitive to one or more regions the solar spectrum, the converter may be sized to contain one to several thousand junctions illuminated with the solar beam parallel to the junctions. In preferred embodiments, neighboring junctions are connected by a highly-conducting layer electrically in series to produce a low series resistance in the converter for a high conversion efficiency. Several converters with different substrates of different bandgaps are assembled to form a composite converter capable of multi-spectral as well as multi-junction conversion of solar energies from the ultraviolet through to the infrared.

## Description

### Technical Field

This invention relates to a multi-junction, multi-spectral, converter apparatus and methods of its manufacture for converting solar energy to electricity, more particularly, to apparatus and methods that use thousands of junctions connected in series to convert a concentrated solar beam into electrical energy over the entire ultraviolet to infrared spectrum containing over 95% of the convertible energy.

### Background Art

**Multi-junction, Multi-spectral Converter**

A multi-junction, multi-spectral converter formed with three distinct semiconductors of InGaP, GaAs and Ge, developed by Emcore and others (Emcore, www.emcore.com, **2006**), and reported recently by MCCONNELL, R., et al. "Next-Generation Photovoltaic Technologies in the United States". 19th European PV Solar Energy Conference and Exhibition, Paris, France. JUNE 2004, p.1., has finally broken the conversion efficiency barrier of 38%, and has a promise of a 50% efficiency in the near future. This tri-material converter comprising three junctions connected in series by a conducting crystalline layer can convert solar energies from the ultraviolet (determined by the 1.9 eV bangap of InGaP), through the visible (determined by the 1.4 eV bandgap of GaAs) to the infrared (determined by the 0.65 eV bandgap of Ge). As an incident solar beam falls onto this structure, it penetrates first the top InGaP junction converting most of the 1.9 eV photons, then transverses through the GaAs junction converting most of the 1.4 eV photons, and finally ends up in the 0.65 eV junction converting most of the 0.65 eV photons into electrons and holes. Generally, the higher the junction crystallinity, the less is the junction recombination processes, and the more electrical current generated by these electron and hole pairs. Alternatively, decreasing junction series resistance will also increase current. In short, this usefulness or the conversion efficiency of the junction is determined predominantly by the junction crystallinity and series resistance.

The wide spectral coverage and the near-perfect match between their lattices for a high crystallinity in the junctions are the main reasons for selecting InGaP, GaAs and Ge for solar conversion. The success of this tri-material system has led to quests for other multi-material systems that might be lower in manufacture cost. In fact, the quest for a converter high in conversion efficiency and low in manufacture cost is the "holy-grail" in the solar conversion field. Innovations abound in this quest. The In₁₋ₓGaₓN system developed recently by J. Wu, et al., reported in Appl. Phys. Lett. 80, 3967, (2002), has a composition "x" that can be varied during growth to obtain a series of continuously-graded bandgaps covering the entire ultraviolet-infrared solar spectrum. It has promise, but its molecular beam epitaxial (MBE) growth is far too costly to be a viable manufacture process, and its junction crystallinity is far too imperfect to be a viable efficient converter in the near future.

**Manufacture**

Improvements in junction crystallinity over the years have not reduced manufacturing cost of converters significantly. The high cost of large sheets of the crystalline material for making conventional converters still determines their high manufacture cost. In the other extreme, the low cost in using thin-film and organic sheets for converters is attractive (see M. Green, "Third Generation Photovoltaics" Springer, Berlin (2003); and S.R. Forrest, Nature, 428, 911 (2004)), but their low efficiency is hardly viable in reducing the cost of converting a unit of energy. One way to reduce the unit cost is to concentrate the sun to over many hundreds of suns onto a small solar converter area made with the highest possible crystallinity on the premise that only a very small converter area is needed to be cost effective in converting a unit of energy. And the sun concentration is made by plastic Fresnel lenses or reflectors that are even lower cost than the thin-film or organic converters.

Conventional converters are seldom used to convert a concentrated beam because they are not optimized for junction thickness, type, configuration, material, junction number, cooling mechanism, or angle of solar-beam incidence. For example, U.S. Pat. Nos. US 7,071,407 (FATERNI, ET AL.) 7/4/2006 ; US 5,405,453 (HO, ET AL.) 4/11/1995 ; US 7,126,052 (FETZER, ET AL.) 10/24/2006 ; US 7,122,734 (FETZER, ET AL.) 10/17/2006; and US 6,252,287 (KURTZ, ET AL.) 6/26/2001 have disclosed detailed tri-material junctions of a few microns thick designed only to convert diffused solar beams with normal incidence to the junctions. As a much thicker junction layer is needed to absorb all the energy from a concentrated beam of over 100 suns, making the thick layer by conventional processes is not cost effectively.

U.S. Pat. Nos. US 4,335,503 (EVANS, JR., ET AL.) 6/22/1982 ; US 4,295,002 (CHAPPELL, ET AL.) 10/13/1981 ; US 4,131,984 (KAPLOW, ET AL.) 1/2/1979 ; and US 3,969,746 (KENDALL, ET AL.) 7/13/1976 have disclosed a V-groove technique for making multiple junctions to absorb a concentrated beam incident parallel to the junctions. But the disclosed converters have too few junctions to take advantage of the beam concentrated to over 500 suns.

U.S. Pat. Nos. US 5,246,506 (ARYA, ET AL.) 9/21/1993 and US 4,271,328 (HAMAKAWA, ET AL.) 6/2/1981 have disclosed stacks of many junctions fabricated with poly-crystalline and amorphous materials, but their conversion efficiency is far too low to justify the concentration of the solar beam to more than a few suns.

U.S. Pat. No. US 6,372,980 (FREUNDLICH) 4/16/2002 ; US 6,340,788 (KING, ET AL.) 1/22/2002 and US 6,174,296 (WANG) 1/16/2001 each disclose tandem junctions of high crystal order, but they all lack an optimized configuration of multiple junctions and multiple spectral bands to take advantage of a concentration of many hundreds of sun to reduce cost.

U.S. Pat. No. US 4,376,872 (EVANS, ET AL.) 3/15/1983 has disclosed a V-grooved solar cell containing many junctions connected in series, but the junctions are not optimized to multiple spectral bands to cover the ultraviolet to infrared spectrum.

**Prior Art Limitations**

Prior art multi-junction, multi-spectral converters for use with concentrated solar radiation are limited in spectral coverage, junction thickness optimization, number of junctions, junction configuration, angle of solar-beam incidence, and low cost manufacturing as follows:
1. Spectral coverage is limited to the bandgaps of 1.9 eV in InGaP, 1.4 eV in GaAs, and 0.65 eV in Ge.
2. The thickness of the multiple junctions is limited to a few microns insufficient to absorb all the photons in the concentrated beam.
3. The tri-material (InGaP, GaAs and Ge) converter is limited to 3 materials.
4. The multi-junction converter is limited to three junctions.
5. The multi-junction converter is limited in crystallinity affording limited conversion efficiency.
6. The junction configuration is limited to planar configuration with one junction on top of another.
7. The angle of incidence of the solar beam is limited the normal incidence to the planar junctions.
8. The solar beam is limited to a concentration of less than 500 suns.
9. The fabrication processes in making converters are limited in mass manufacturing at low cost, except in manufacturing in large sheets of low-efficiency thin-film or organic solar converters.

It is therefore an object of the invention to provide a multi-junction, multi-spectral converter to cover the entire ultraviolet to infrared solar spectrum.

It is another object to provide a multi-junction, multi-spectral converter with an optimum junction thickness to absorb the entire concentrated solar beam.

It is another object to provide a multi-junction, multi-spectral converter with as many different materials as required to cover the entire solar spectrum from ultraviolet to infrared.

It is another object to provide a multi-junction, multi-spectral converter with as many junctions as required to achieve a high conversion efficiency.

It is another object to provide a multi-junction, multi-spectral converter with as high a junction crystallinity as required to achieve a high conversion efficiency.

It is another object to provide a multi-junction, multi-spectral converter with a vertical-junction configuration, whereby all junctions are illuminated simultaneously with equal amount of solar radiation to achieve a high conversion efficiency.

It is another object to provide a multi-junction, multi-spectral converter with a solar beam incident parallel to all the junctions to achieve a high conversion efficiency.

It is another object to provide a multi-junction, multi-spectral converter to receive as many concentrated suns as required to achieve a high conversion efficiency and a low cost in converting a unit of energy.

It is another object to provide a multi-junction, multi-spectral converter with high conversion efficiency that can be mass manufactured at low cost.

### Disclosure of Invention

The invention comprises several general aspects, each of which can, if desired, be combined with additional features, including features disclosed and/or not disclosed herein, resulting in combinations representing more detailed optional embodiments of these aspects.

In accordance with this invention, there is provided a multi-junction, multi-spectral converter for generating electrical energy via the conversion of solar radiation, comprising a one or more junctions wherein each junction may be of a type specific to at least one energy bandgap.

Like a microchip, it may be processed to contain one junction to many thousands of junctions on a wafer substrate of high crystallinity for high conversion efficiency. Each junction is a micro photovoltaic junction structure consisting of two parallel, thin, and highly-doped (n⁺ and p⁺) layers sandwiching a lightly-doped n or p layer of high crystallinity.

Many converters may be obtained from each substrate processed. Different substrates may be used to fabricate different converters with different energy bandgaps sensitive to different parts of the solar spectrum.

Thus, when several different converters are assembled together they form a composite converter with a multi-spectral sensitivity capable of converting energies from the ultraviolet (-2 eV) to the infrared (-0.65 eV) parts of the solar spectrum.

This invention emphasizes: (a) making the high-efficiency photovoltaic junctions; (b) mass producing thousands of these junctions into a microchip or die form; and assembling as many different converters as required to cover the entire solar spectrum to form the composite converter for concentrated-sun conversion. In accordance with this invention, converters with thousands of parallel junctions may be mass produced on substrates of different bandgaps at low cost, and may be assembled into a composite converter with multi-spectral capability to convert a concentrated sun beam at a low unit energy cost.

A first aspect of this invention is a solar converter for converting incoming solar beam to electricity via at least two adjacent layers of solar cells, wherein each layer comprises at least one junction, and wherein at least one layer may be bonded to at least one other layer without requiring that the lattices of adjacent layers match.

In various embodiments of this first aspect, a layer may comprise junctions of a type specific to at least one energy bandgap. In various other embodiments, a layer may comprise junctions of a first type specific to at least one first energy bandgap, and junctions of at least one other type specific to an energy bandgap different than said first type.

In other embodiments, each layer may comprise at least 10 individual junctions, or may comprise at least 100 individual junctions. In still other embodiments the converter may comprise at least 10 multi-junction layers, or may comprise at least 100 multi-junction layers. In various related embodiments the density of junctions per unit of area may be at least 1000 junctions per cm².

In certain embodiments, the junctions may be disposed parallel to an incident solar beam, whereby each of the junctions may be illuminated by an approximately equal amount of solar energy from said incoming solar beam. In other embodiments, the junctions may be connected electrically in series.

In some embodiments, each layer may be individually processed/created independently from any other layer. In other embodiments, a first layer and at least one other layer may be processed/created from different substrates. In various other embodiments, the junctions may be created via semiconductor fabrication techniques or organically growth.

In certain embodiments, a first layer may capture energies of at least one bandgap while allowing energies of at least one lower bandgap to pass through to at least one layer beneath it. Various levels of layers may be stacked in such a way as to absorb solar energies from multiple spectrums simultaneously.

In various forms of this embodiment, the junctions may have a bandgap of at least: 1.8 eV, 1.4eV, 1.1eV, and/or 0.6eV, in order to convert solar energies in the ultraviolet, visible, infrared, and long infrared spectrums. When processed on a semiconductor substrate, the substrates may include Diamond, GaP, AlAs, InGaP, GaAs, Si, Ge, InGaAs and InAs.

In another embodiment of this invention the photovoltaic junction may comprise vertical or sloped walls. In one form of this embodiment, one wall may be doped with n+-type carriers and the other wall doped with p+-type carriers. In related forms, the region sandwiched by these walls may be doped with n-type or p+-type carriers. In still other related forms, the first wall and/or the second wall may be perpendicular to the incoming solar beam and/or may be perpendicular to the nominal plane of the junction's layer.

The converter may comprise vertical walls to form parallel junctions, allowing a uniform generation of electron-hole pairs and a uniform high field to occur within the junction region, or may comprise sloped walls whereby simple implants can be carried out easily to form multiple thick junctions and to provide metal contacts for radiative cooling.

In various other embodiments the junction may comprise a width smaller than the diffusion length of minority carriers generated in the junction by the incoming solar beam. In certain forms, a high electric field may extend across the entire width of a junction, or across an entire region. In certain other forms, a first junction and at least one other junction may be the same or different widths. In various related forms, a first layer and at least one other layer may be of the same or different thicknesses.

In a particular embodiment of this first aspect, a composite converter may be comprised of at least two converters, wherein the converters are stacked such that at least two bandgaps are simultaneously converted.

In certain forms of this embodiment, each converter may comprise a junction width optimized for a specific energy bandgap. Different converters may have different junction widths thereby maximizing conversion efficiency.

In other forms, the at least two converters may be aligned front-most to rear-most in order from highest to lowest bandgap, and wherein the solar beam that is not converted in the front-most converters(s) traverses through to be converted in subsequent converter(s) without interference.

In various forms of this embodiment, the converters of the composite converter may be connected electrically in series, whereby the converter voltages are additive. In still other forms, the converters of the composite converter may be loosely bonded to their adjacent neighbors so that their different thermal expansion rates will not distort the disposition of the composite converter.

In certain forms, each converter of the composite converter may be separated from its neighbor(s) by a Fabry-Perot cavity wherein the incident solar beam undergoes multiple reflections in a specific spectral wavelength. In certain forms of this embodiment the Fabry-Perot cavity may comprise a cavity spacing determined by the thickness of a layer of silicon oxide. In certain other forms, the thickness of the silicon oxide layer may be varied to maximize the specific solar energy absorption within each converter, whereby the total absorption of the solar beam will be maximized.

In other forms, the composite converter may further comprise at least one radiator intimately integrated with the composite converter, whereby the composite converter, when illuminated by multiple suns, is kept at a temperature below 250°C. In various related forms, the radiator(s) may comprise passive and/or active cooling.

In another embodiment, the composite converter when used to convert concentrated solar beam may be integrated with a large, low-cost Fresnel lens, which focuses the solar beam onto the converter. When so focused, the solar beam may have a strength equal to multiple suns.

In various embodiments, the composite converter may comprise any number and any type of converters whereby a desired spectral characteristic may be established to suit the application in solar conversion. For example:
- Used on satellites, a composite converter with wide-bandgap converters to capture more ultraviolet energies that are rich in space.
- Used on an aircraft, a composite converter with only GaAs converters to convert a He/Ne laser beamed from elsewhere.
- Used on a remote sensor, a composite converter with Ge converters to convert a Neodynium laser energy beamed from an aircraft.
- Used on a notebooks computer, a composite converter with 3 different junctions (InGaP, GaAs and Ge) to convert diffused solar energy.

A second aspect of this invention is a method for fabricating a converter, comprising: thinning a substrate to an thickness appropriate to the energy bandgap of the substrate; delineating the substrate into dies that form the converters; forming material trenches on the substrate using standard photolithography; implanting the trench walls to form the n+-n-p+ multiple junctions on the substrate; depositing metal layer over implanted walls; collapsing the walls by vacuum suction; bonding walls to form the converter by heating to the eutectic temperature; assembling as many different energy converters to form the composite converter; and attaching a thermal radiator to the composite converter. In certain forms of this embodiment, a Fresnel lens may be added to increase the efficiency of the system.

A third aspect of this invention includes a method for fabricating a converter comprising: thinning a substrate to an thickness appropriate to the energy bandgap of the substrate; implanting the substrate to a p+-doped layer, depositing a thin eutectic metal layer, transfer the substrate to another glass holder to expose the other side of the substrate, implanting the second side to a n+-doped layer, depositing a thin metal layer, delineating the substrate into dies, removing dies from glass carrier, assembling as many different energy converters to form the composite converter; and attaching a thermal radiator to the composite converter. In certain forms of this embodiment, a Fresnel lens may be added to increase the efficiency of the system.

In another embodiment is a method for fabricating a converter comprising: thinning a substrate to an thickness appropriate to the energy bandgap of the substrate; delineating the substrate into dies that form the converters; forming material trenches on the substrate using standard photolithography; implanting the trench walls to form the n+-n-p+ multiple junctions on the substrate; depositing metal layer over implanted walls; transferring substrate to a pre-stretched elastomer carrier; collapsing the walls by releasing the pre-stretch in the elastomer carrier; bonding walls to form the converter by heating to the eutectic temperature; assembling as many different energy converters to form the composite converter; and attaching a thermal radiator to the composite converter. In certain forms of this embodiment, a Fresnel lens may be added to increase the efficiency of the system.

In yet another embodiment is a method for fabricating a converter comprising: thinning a substrate to an thickness appropriate to the energy bandgap of the substrate; delineating the substrate into dies that form the converters; forming V-grooved material trenches on the substrate using standard photolithography; implanting the V-grooved trench walls to form the n+-n-p+ multiple junctions on the substrate; depositing metal layer over implanted walls; electroplating implanted walls to form thermal contacts with the radiator cooler; assembling as many different energy converters to form the composite converter; and attaching a thermal radiator to the composite converter. In certain forms of this embodiment, a Fresnel lens may be added to increase the efficiency of the system.

In still another embodiment is a method for fabricating a converter comprising: starting with a silicon-on-insulator (SOI) substrate containing a silicon epilayer of about a few microns thick; growing by metal-organic chemical disposition (MOCVD) a buffer layer of SiGe for lattice matching on the epilayer; growing by MOCVD an n+-type layer on top of the SiGe layer about 0.01 micron thick; growing by MOCVD an n-type layer on top of the n+-type layer to form the n-type junction region about 5 micron thick; growing by MOCVD a p+-type layer about 0.01 micron thick on top of the n-type layer of the n-type junction region to form the n+-n-p+ junction; repeating all the MOCVD growths to form a stack of 20 n+-n-p+ junctions to a total thickness of about 100 micron; depositing an eutectic metal layer; delineating the substrate into dies that form the converters each containing 20 junctions; bonding the substrate onto a plastic carrier with dies close to the carrier; removing the silicon substrate from the SOI substrate by etching the silicon oxide leaving the dies attached to the plastic carrier; removing the Si epilayer and the SiGe layer from dies on the plastic carrier; depositing an eutectic layer on dies; removing excessive eutectic metal layer from dies edge; removing dies from plastic carrier; assembling 50 dies together one on top of another to form a stack of 1,000 junctions; heating the stack to 270°C to form the eutectic bonds within the stack; repeating the above steps with different semiconductors (e.g. GaP, InGaP, GaAs, Si and Ge) grown by MOCVD to form the different-energy converters; assembling the different-energy converters to form the composite converter; and attaching a thermal radiator to the composite converter. Thus, the composite is ready for assembly with a Fresnel lens into a conversion system.

In various embodiments of this aspect, the substrate may be Diamond, SiC, AlAs, GaP, AlAs, InGaP, GaAs, Si, Ge, InGaAs, and InAs.

**Advantages of the Invention**

The following discussion of advantages is not intended to limit the scope of the invention, or to suggest that every form of the invention will have all of the following advantages. As will be seen from the remainder of this disclosure, the present invention provides a variety of features. These can be used in different combinations. The different combinations are referred to as embodiments. Most embodiments will not include all of the disclosed features. Some simple embodiments can include a very limited selection of these features. Those embodiments may have only one or a few of the advantages described below. Other preferred embodiments will combine more of these features, and will reflect more of the following advantages. Particularly preferred embodiments, that incorporate many of these features, will have most if not all of these advantages. Moreover, additional advantages, not disclosed herein, that are inherent in certain embodiments of the invention, will become apparent to those who practice or carefully consider the invention.

The foregoing and other objects of the invention are achieved by the converter apparatus and systems described herein which overcome problems inherent in traditional solar converters, and in the use of such converters in fields such as solar power plants, rural community solar energy conversion, household solar-energy generators, solar generator for commercial buildings, industrial plants and automotive vehicles, and solar generators for portable electronics such as cell phones, PCs, notebooks, and PDAs.

In particular, a multi-junction, multi-spectral converter is, by its nature, a small compact device that uses only a small amount of the highest crystalline material for fabrication to achieve the highest possible conversion efficiency. As such, one of the first advantages is that the converter is fabricated cost-effectively by simple conventional microelectronics processes in large quantities on a single crystalline wafer substrate.

The next advantage is it comprises over a thousand junctions of the highest internal quantum efficiency fabricated on a crystalline substrate. This multi-junction configuration has the advantage of being more tolerant to the amount of series resistance in the converter to achieve a high conversion efficiency.

The third advantage is the converters can be fabricated using the same process on any crystalline substrate with an energy bandgap range from about 3.5 eV to about 0.2 eV to obtains converters with different spectral responses to different parts of the solar spectrum ranging from the ultraviolet to infrared. This leads to the assembly of as many different-energy converters (not just three, as in the tri-material converter) as needed into a composite converter capable of converting the entire energy content of the solar beam from ultraviolet to infrared.

The fourth advantage is the vertical-junction configuration of the converter in which all junctions are illuminated simultaneously with equal solar intensity to achieve a high conversion efficiency. This leads to the advantage of the solar beam incident parallel to all the junctions to achieve a high conversion efficiency.

The fifth advantage is that the converter can receive as many concentrated suns as required to achieve a high conversion efficiency and a low cost in converting a unit of energy.

The sixth advantage is that the composite (multi-junction, multi-spectral) converter with high conversion efficiency can be mass manufactured at low cost with simple processing steps, bonding methods and assembly procedures, all of which are available commercially. This advantage leads to a low unit cost in installing a solar conversion facility in large scale rivalling that of installing a fossil-fuelled facility.

**Brief Description of Figures in the Drawings**

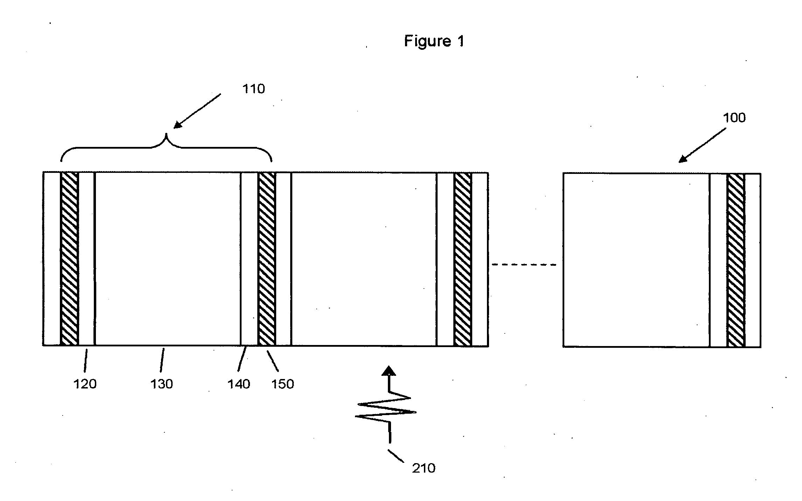

**Figure 1****: Multi-junction Converter with Vertical Walls**

Figure 1 comprises a multi-junction converter 100 and photovoltaic junctions with vertical walls 110.

**Figure 2****: Multi-junction Converter with Sloped Walls**

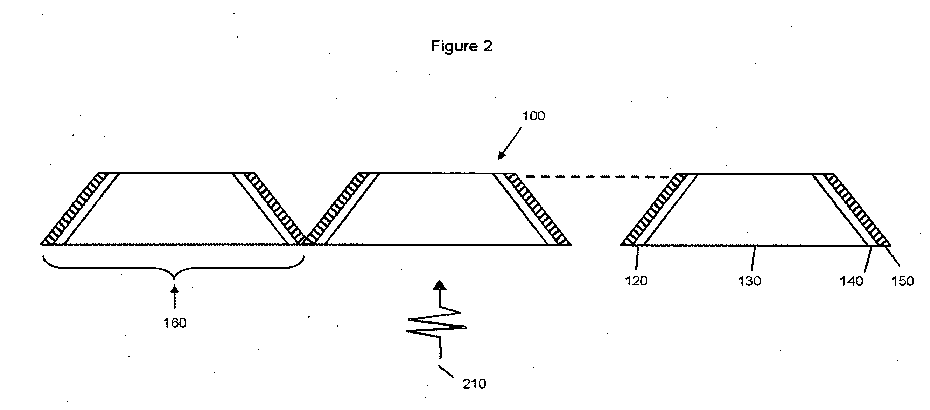

Figure 2 comprises a multi-junction converter 100 and photovoltaic junctions with sloped walls 160.

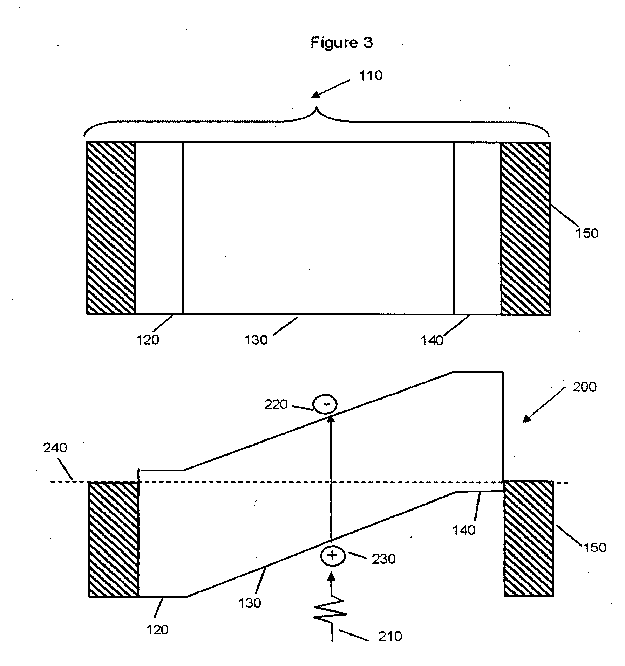

**Figure 3****: Photovoltic Junction with Vertical walls**

Figure 3 comprises a photovoltaic junction with vertical walls 110 and its energy band diagram 200.

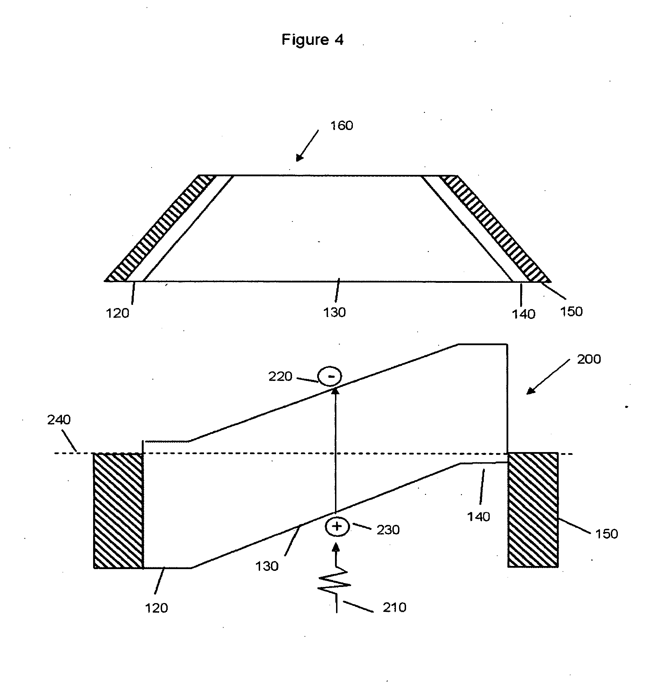

**Figure 4****: Photovoltic Junction with Sloped walls**

Figure 4 comprises a photovoltaic junction with sloped walls 160 and its energy band diagram 200.

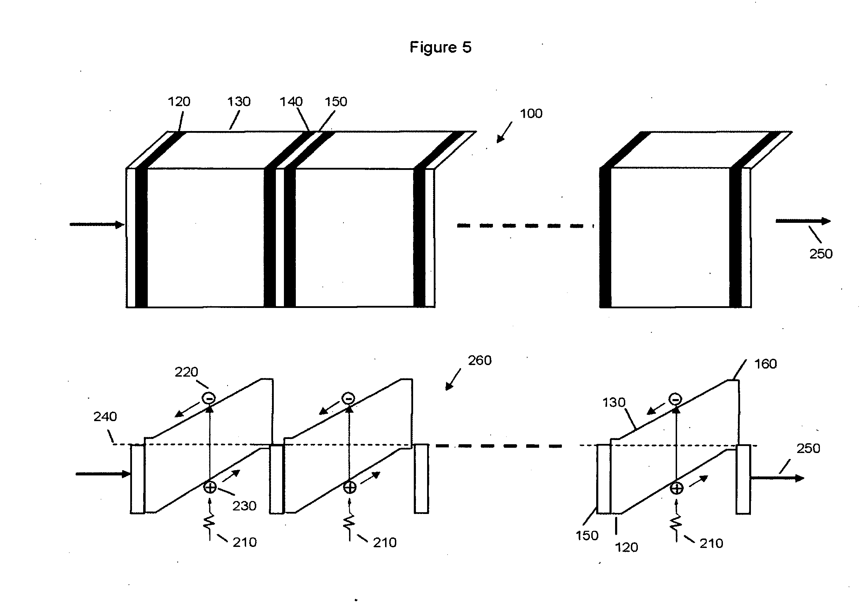

**Figure 5****: 3-D IView of a Multi-junction Converter with Vertical Walls**

Figure 5 comprises a 3-D multi-junction converter 100 with vertical junctions 110 and its energy band diagram 260.

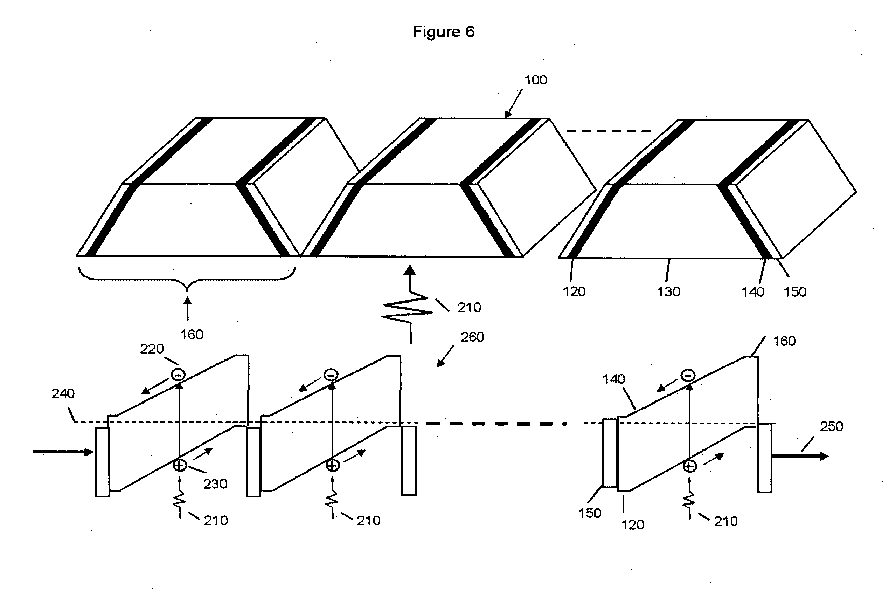

**Figure 6****: 3-D View of a Multi-junction Converter with Sloped Walls**

Figure 6 comprises a 3-D multi-junction converter 100 with sloped junctions 160 and its energy band diagram 260.

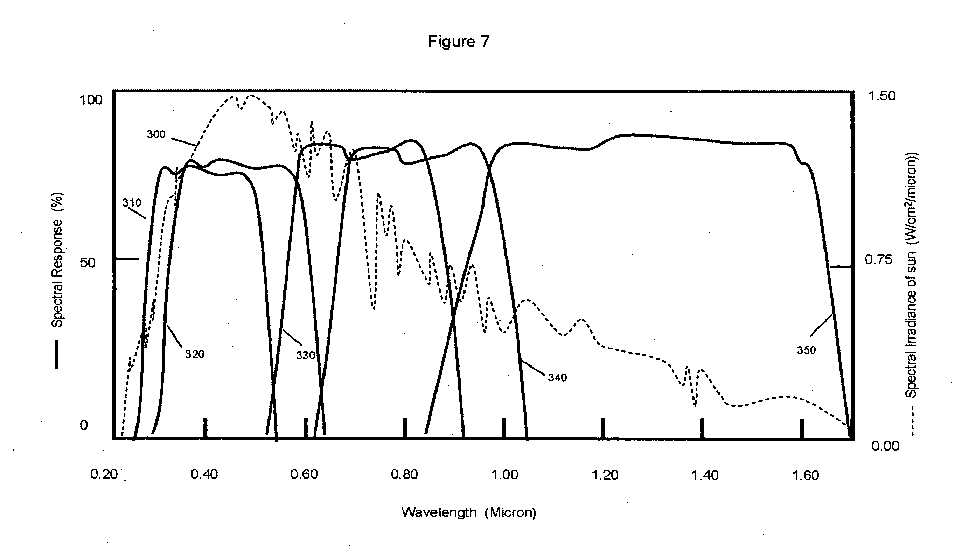

**Figure 7****: Solar Spectrum Graph**

Figure 7 comprises a plot of the solar spectrum 300 against wavelength and the spectral response of semiconductors GaP 310, InGaP 320, GaAs 330, Si 340 and Ge 350.

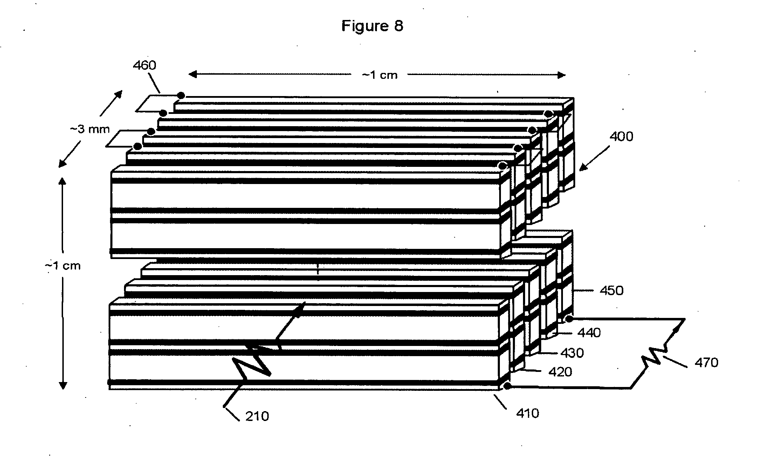

**Figure 8****: Composite Converter**

Figure 8 comprises a composite converter 400 with GaP 410, InGaP 420, GaAs 430, Si 440, and Ge 450 converters.

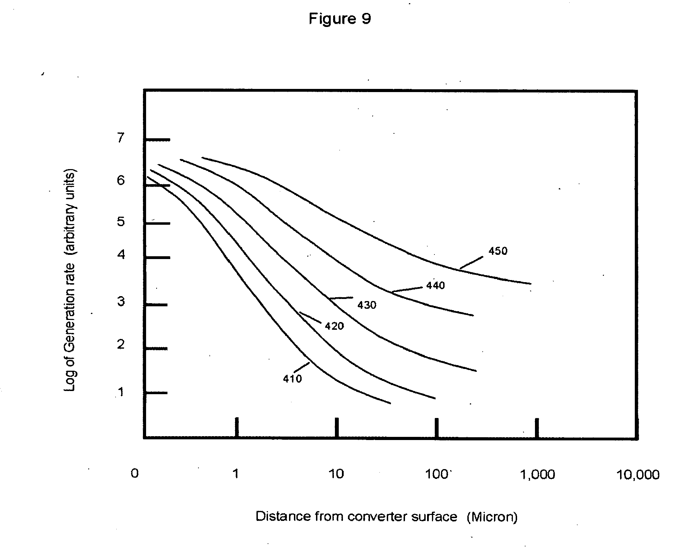

**Figure 9****: Carrier Generation vs. Converter Types**

Figure 9 comprises graphs (410-450) of generation rate of electron-hole pairs vs. distance from converter surface for different converters.

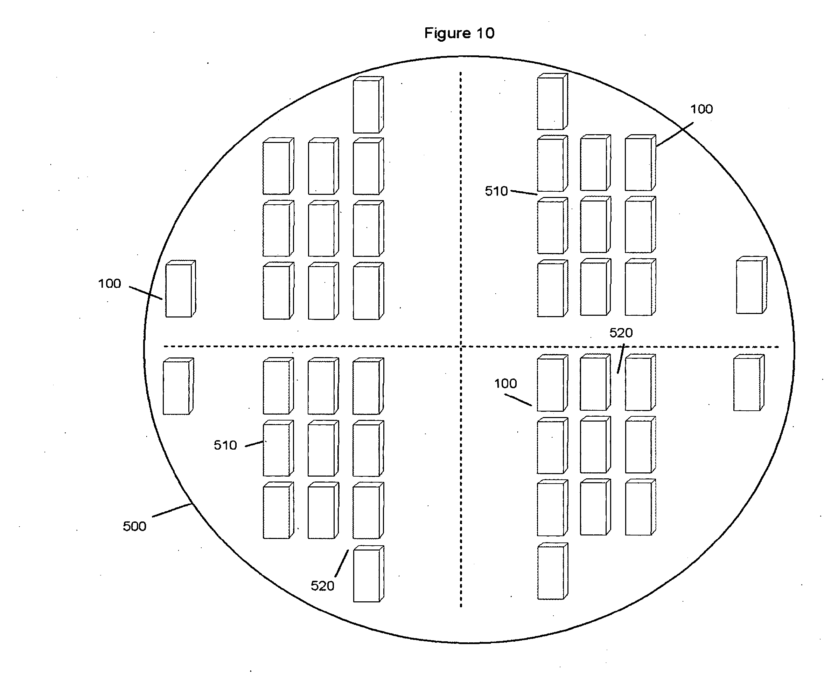

**Figure 10****: Converters Fabricated on Crystalline Substrate**

Figure 10 comprises converters 100 fabricated on a crystalline substrate 500.

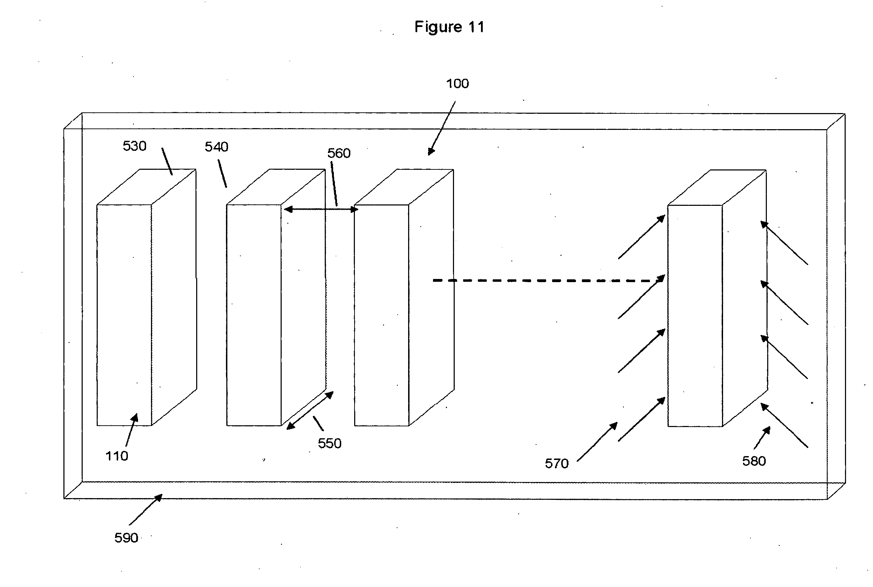

**Figure 11****: Converters Fabricated by Implanting Vertical Walls**

Figure 11 comprises a converter100 with vertical walls formed by implant.

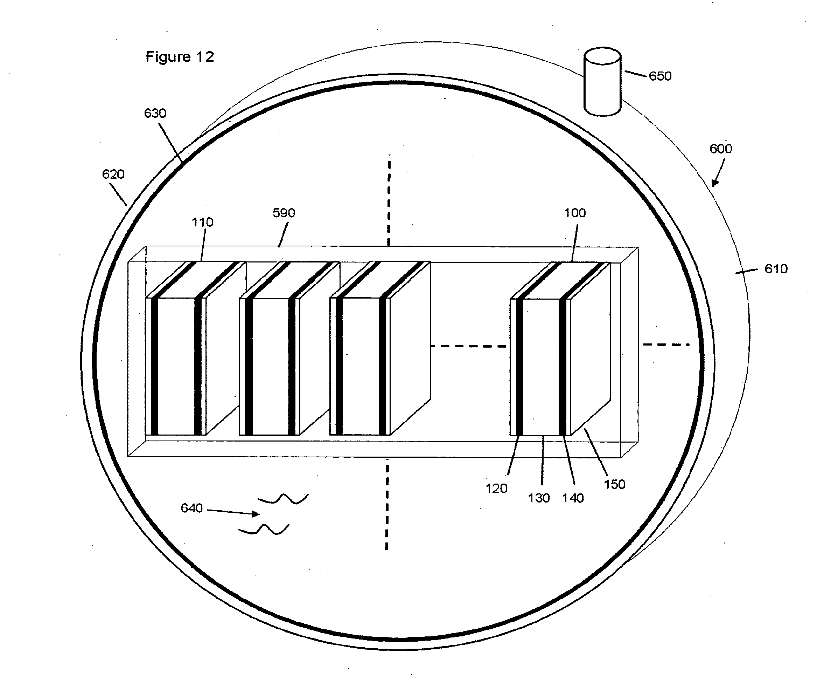

**Figure 12****: Rig for Fabricating Converters with Vertical Walls**

Figure 12 comprises a rig 600 for fabricating the converters100 with vertical walls by implant.

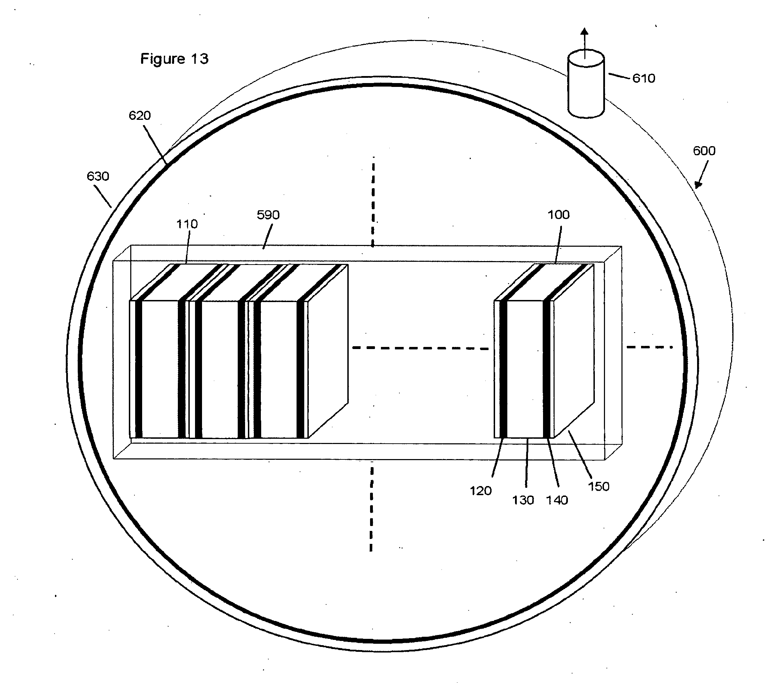

**Figure 13****: Evacuated Rig for Forming Converter**

Figure 12 comprises an evacuated rig 600 for coalescing vertical walls to form the converters100.

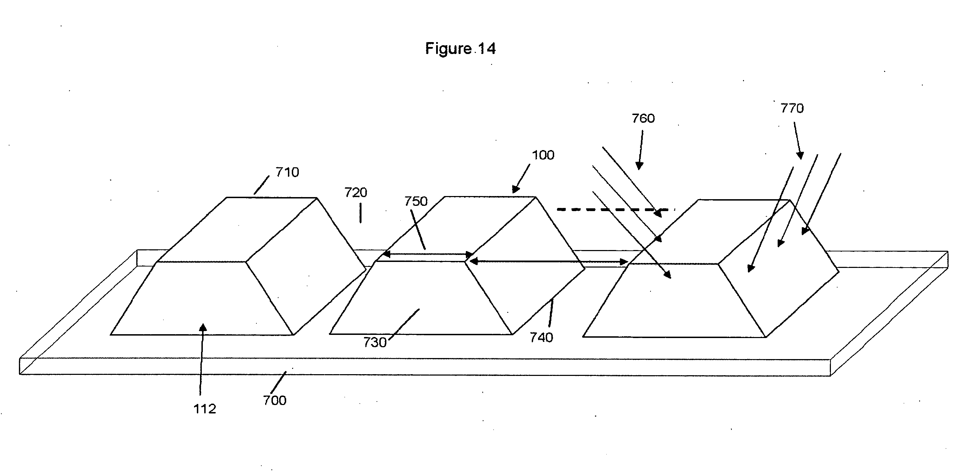

**Figure 14****: Converters Fabricated by Implanting Sloped Walls**

Figure 14 comprises a converter 100 with sloped walls formed by implant.

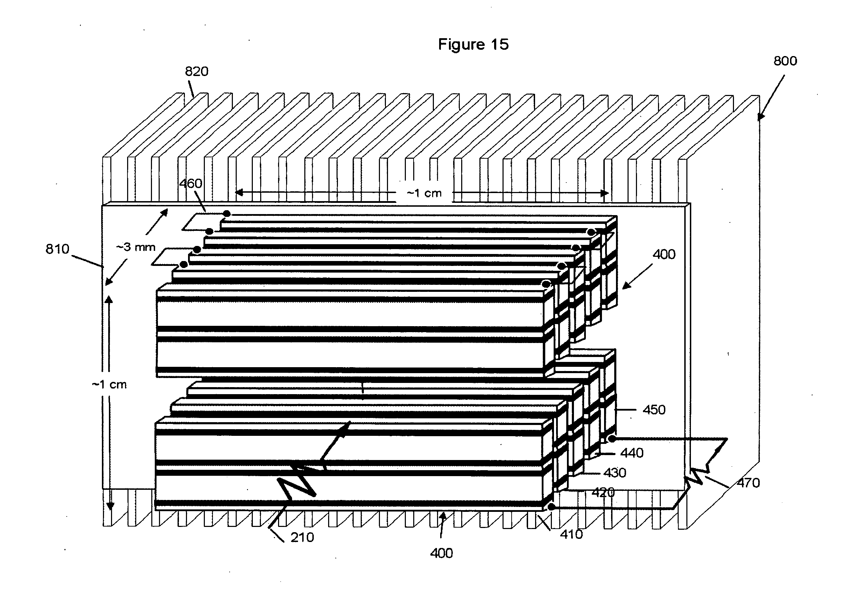

**Figure 15****: Composite Converter with Radiator**

Figure 15 comprises a composite converter 400 and a radiator 800.

F**igure 16 : Composite Converter Integrated with Fresnel Lens**

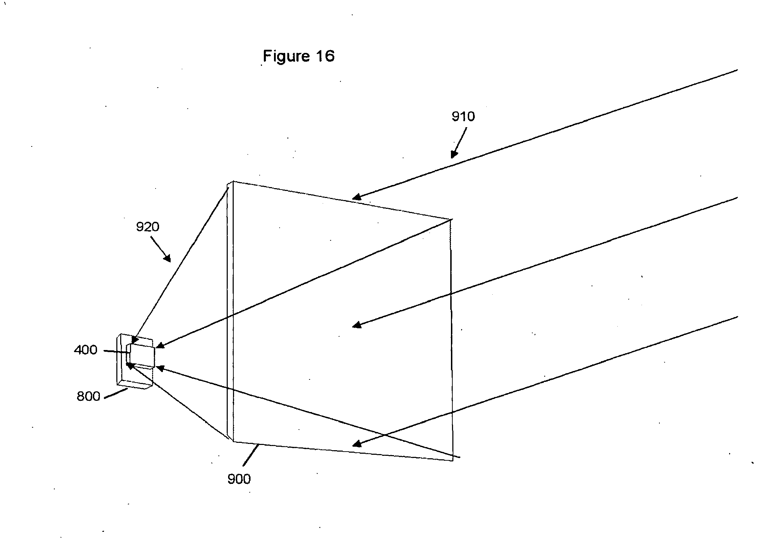

Figure 16 comprises a composite converter 400, radiator 800, and a Fresnel lens 900.

### Detailed Description of the Drawings

**Figure 1****: Multi-junction Converter with Vertical Walls**

Figure 1 is a 2-D view of a multi-junction converter 100 with vertical walls, showing three photovoltaic junctions 110. The converter may contain over a thousand identical junctions 110 in parallel, each is formed by a highly-doped n+ layer 120 and a highly-doped p+ layer 140 sandwiching a highly-crystalline n layer 130.

**Figure 2****: Multi-junction Converter with Sloped Walls**

Figure 2 is a 2-D view of a multi-junction converter 100 with sloped walls, showing three photovoltaic junctions 160. The converter may contain over a thousand identical junctions 160, each is formed by a highly-doped n+ layer 120 and a highly-doped p+ layer 140 sandwiching a highly-crystalline n layer 130.

**Figure 3****: Photovoltic Junction with Vertical Walls**

Figure 3 is a detailed view of a single photovoltaic junction with vertical walls 110 formed with a highly-doped n+ layer 120, and a highly-crystalline n layer 130, and a highly-doped p+ region 140, sandwiched between two metal layers 150, which may be eutectic or conventional conducting metal.

It also shows an energy band diagram 200 corresponding to the junction 110, showing the incident solar beam 210 generating an electron 220 and a hole 230.

**Figure 4****: Photovoltic Junction with Sloped Walls**

Figure 4 is a detailed view of a single photovoltaic junction with sloped walls 160 formed with a highly-doped n+ layer 120, and a highly-crystalline n layer 130, and a highly-doped p+ region 140, sandwiched between two metal layers 150, which may be eutectic or conventional conducting metal.

It also shows an energy band diagram 200 corresponding to the junction 160, showing the incident solar beam 210 generating an electron 220 and a hole 230.

This invention uses both the vertical and sloped junctions to form the multi-junction converter, depending on the substrate type used for fabrication. For example, when the Si substrate is used, the sloped junctions are easily made by a simple implant of the sloped walls, because V-grooves for the sloped walls can be easily etched on Si; and when GaP, InGaP, GaAs and Ge substrates are used, implant of vertical walls are used. In fact any substrates may use the implant of vertical walls without resorting to implant of sloped walls. Using V-grooves for implant involves fewer preparatory steps than the implant of vertical walls, otherwise the implant of both wall types is straightforward.

**Figure 5****: 3-D View of a Multi-junction Converter with Vertical Walls**

Figure 5 is a detailed 3-D view of a multi-junction converter 100 with vertical walls, showing the relative thickness of the different layers of the vertical junctions 110, highly-doped n+ layer 120, lowly-doped n junction layer130, highly-doped p+ layer 140, and the metal connecting layer 150. It also shows the energy band diagram 200 corresponding to the multi-junction converter 100.

**Figure 6****: 3-D View of a Multi-junction Converter with Sloped Walls**

Figure 6 is a detailed 3-D view of a multi-junction converter 100 with sloped walls, showing the relative thickness of the different layers of the sloped junctions 160, highly-doped n+ layer 120, lowly-doped n junction layer130, highly-doped p+ layer 140, and the metal connecting layer 150. It also shows the energy band diagram 200 corresponding to the multi-junction converter 100.

**Figure 7****: Solar Spectrum Graph**

Figure 7 is a plot of the spectral irradiance against wavelength of the solar spectrum 300 focused onto the multi-spectral converter 100, overlapping the spectral response of the different converters made on GaP 310, InGaP 320, GaAs 330, Si 340 and Ge 350 substrates. These five converters with different energy responses converting the entire energy content of the solar spectrum from ultraviolet to infrared, leaving very little solar energy that is not converted by these converters.

**Figure 8****: Composite Converter**

Figure 8 is a composite converter 400 with GaP converter 410, InGaP converter 420, GaAs converter 430, Si converter 440, and Ge converter 450 connected electrically in series together forming the composite converter 400 of thousands of junctions whose voltages are additive. It also shows the wire bonds 460 and external load 470.

**Figure 9****: Carrier Generation vs. Converter Types**

Figure 9 shows graphs of generation rate of electron-hole pairs vs. distance from converter surface for different converters, showing that for the large-energy-bandgap converters their thickness need not by large to convert most of the energetic photons into electron-hole pairs. But, for converting the less energetic photons, the low-energy-bandgap converters (such as Si and Ge converters, 440 and 450) had to be much thicker than those of GaP 410, InGaP 420 and GaAs 430.

**Figure 10****: Converters Fabricated on Crystalline Substrate**

Figure 10 shows a batch of multi-junction converters 100 fabricated on a crystalline substrate wafer 500. The converters 100 are fully delineated by conventional photolithography with streets 510 and avenues 520 into the proper size for assembly into the composite converter 400.

**Figure 11****: Converters Fabricated by Implanting Vertical Walls**

Figure 11 shows how the vertical walls of photovoltaic junctions 110 are made by etching the material islands 530 and trenches 540 to support two implants, 570 and 580. It also shows the trench depth 550 and width 560.

When tall walls (such as those in Si 440 and Ge 450 converters) are needed to be implanted, the trenches must be made wide in order for the tall walls of the trenches to be implanted readily. GaP, InGaP and GaAs Converters (410,420,and 430), walls need not by tall (10 micron or less will suffice), then conventional photolithography may be used easily to prepare for normal implant.

**Figure 12****: Rig for Fabricating Vertical Walls**

Figure 12 shows a special rig fixture 600 formed with a metal plate 610 and a glass cover plate 620 sealing a processed wafer 500 with an O-ring 630. The processed wafer 500 containing delineated converters 100 on a glass substrate 590 is washed with a solvent 640 followed by rinsing water introduced into the sealed wafer to release the etched junctions 110.

**Figure 13****: Evacuated Rig for Forming Converter**

Figure 13 shows the special rig fixture 600 being evacuated by sucking out all the solvent 640 and rinsing water through a vacuum outlet 620 to coalesce all the etched junctions 110 together, leaving the junction walls touching.

**Figure 14** **: Converters Fabricated by Implanting Sloped Walls**

Figure 14 shows the V-groove etched into the Si substrate forming the sloped walls of the converter 100 to allow the implants 760 and 770 of the walls without having to use trenches as shown in Figure 11. This sloped wall configuration is for fabricating converters on Si substrates only. It also shows material height 730 and V-groove width 740.

**Figure 15****: Composite Converter with Radiator**

Figure 15 details a composite converter 400 integrated with a radiator 800, showing a metal plate 810 integrating the converter 400 to the radiator fins 820 to radiate heat from the converter into space.

Figure 16: Composite Conveter integrated with Fresnel Lens

Figure 16 shows a composite converter 400, radiator 800, and a Fresnel lens 900 focusing the solar beam 910 onto the converter 400.

### Best Mode for Carrying Out the Invention

**Multi-junction Converter 100**

As shown in Figures1-5, a multi-junction converter 100 may comprise one to several thousand photovoltaic junctions 110, each of which is fabricated with a highly-doped (10¹⁹/cm³) n+ semiconductor layer 120, a lowly-doped (10¹⁶/cm³) n-type semiconductor layer 130 of high crystallinity, and a highly-doped (10¹⁹/cm³) p+ semiconductor layer 140. A thin metal or eutectic metal layer 150 is made between the adjacent n+ and p+ layers to decrease the overall series resistance of the converter 100.

In a preferred embodiment, the multi-junction converter 100 is fabricated with all junctions 110 parallel and connected electrically in series so that the junction voltages are additive, as inferred from Figures 1 and 5.

The first element in this preferred embodiment is that the junction regions and the doped layers of the multi-junction converter 100 are of the highest crystalline order for the highest possible internal quantum efficiency, even at the expense of the high cost involved in the initial converter fabrication. As it is apparent to experts and practitioners in this field, a high conversion efficiency resulting from a high quantum efficiency would lead to an ultimate low-unit cost in energy conversion.

The second element in this preferred embodiment is that over a thousand parallel junctions are fabricated in the converter 100 within a 1 cm x 1 cm microchip (or die) format on which a concentrated sun beam might be focused. As it is apparent to experts and practitioners in this field, this format leads to an efficient use of the costly wafer for fabrication and to the relaxation of the need for low series resistance in the converter 100 to achieve a high conversion efficiency - because a low converter current will suffice to sustain a high conversion efficiency.

The third element in this preferred embodiment is that the converter 100 can be made with different semiconductor substrates with different bandgaps to cover the entire solar spectrum from ultraviolet to infrared, as illustrated in Figure 7, allowing the construction of a truly multi-spectral converter 400 comprising of five converters using semiconductors GaP 410, InGaP 420, GaAs 430, Si 440, and Ge 450.

The fourth element in this preferred embodiment is that the converter 100 is made using conventional implant either on converter with vertical walls or with sloped walls leading to cost-effective methods of fabrication using conventional photolithography.

**Photovoltaic Junction 110**

The photovoltaic junction in this invention can be made into a vertical-wall photovoltaic junction 110 or a sloped-wall photovoltaic junction 160, both with identical energy bandgap diagram 200, as shown in Figures 3 and 4. The doping structure of these junctions (110 and 160) are also identical. It is n+-n-p+, made with an n+-doped layer and a p+-doped layer sandwiching an n-doped layer - all layers are of the highest crystallinity.

The first element of this junction structure is that it possesses a high quantum efficiency because the surface recombination is much less in the n+-n-p+ structure than in the n+-p-p+ structure, even though the minority-carrier (hole) diffusion length in the n layer of the n+-n-p+ structure is much shorter than the minority-carrier (electron) diffusion length in the p layer of the n+-p-p+ structure.

The second element of this junction structure is that its quantum efficiency is further enhanced by making the width of n layer 130 in the n+-n-p+ structure about 10 microns, much shorter than the minority-carrier (hole) diffusion length in the n layer. This short width of the n layer 130 also allows making over a thousand junctions within 1 cm length, the desired linear dimension of the converter 100.

The third element of this junction structure is that its n+ and p+ layers are readily made by commercial implant to a thickness no more than 100 Angstroms.

The fourth element of this junction structure is that high field region of the junction extends across the entire width of the n layer 130 enhancing its quantum efficiency in the process.

**Composite Converter 400**

Over 98% of the solar power falls within the ultraviolet to infrared spectral region, as shown in Figure 7 in the solar spectrum 300 - which is a plot of solar irradiance vs. wavelength. The use of only one converter 100, say a converter made with a Si substrate 340, would not be able to convert all the solar power emanate from the entire solar spectrum 300. From Figure 7, we see clearly that five converters responding to five different spectral regions across the ultraviolet to infrared spectrum are needed to convert all the solar power emanated from the sun.

The first element of this multi-spectral converter 400 is that it can be made with different semiconductor substrates having different bandgaps to cover the entire solar spectrum from ultraviolet to infrared, as illustrated in Figure 7, allowing the construction of a truly multi-spectral converter 400 comprising of five (or more) converters using semiconductors GaP 410, InGaP 420, GaAs 430, Si 440, and Ge 450, as shown in Figure 8.

The second element of this multi-spectral converter 400 is that all five converters GaP 410, InGaP 420, GaAs 430, Si 440, and Ge 450 are made using identical n+-n-p+ structure and identical fabrication process.

The third element of this multi-spectral converter 400 is that all five converters GaP 410, InGaP 420, GaAs 430, Si 440, and Ge 450 are made with commercial substrates that are of the highest crystallinity.

The fourth element of this multi-spectral converter 400 is that all five converters GaP 410, InGaP 420, GaAs 430, Si 440, and Ge 450 combine is capable of a conversion efficiency greater than the current 39%.

Composition of Composite Converter 400

The composition of the composite converter 400, shown in Figure 8, comprises five or more converters using semiconductors GaP 410, InGaP 420, GaAs 430, Si 440, and Ge 450. For those who are experienced in this field, it can be seen that many other semiconductor types can be used to cover the entire solar spectrum, and these semiconductors can easily be made into the multi-junction converter 100 identical to those shown in Figures 5 and 6. Furthermore, identical photovoltaic junctions 110 to those shown in Figures 3 and 4 could also be made with any semiconductors in additional to those mentioned above.

The first element of the composition of the composite converter 400 is that any number of converters may be connected in series together to form the composite converter 400.

The second element of the composition of the composite converter 400 is that all the different converters with different energy bandgaps are connected by simple wire bonding 460 at the ends of each converter, as shown in Figure 8. Simple wire bonding is also used to connect the composite converter 400 to an external load 470.

The third element of the composition of the composite converter 400 is that the widest-bandgap converter, GaP 410 is mounted at the front-most position to receive the solar beam first, while the lowest-bandgap converter, Ge 450, is mounted at the back-most position. This disposition of the different converters is optimized so that the GaP converter 410 would first convert the ultraviolet solar energy, the least penetrating radiation as shown in Figure 9, while the more penetrating infrared radiation is allowed to penetrate further into the back-most Ge converter 450 before being converted in electrical energy. In this way, all the solar energy at different wavelengths will be converted effectively without one converter interfering another as the solar beam transverse through the composite converter structure 400.

The fourth element of the composition of the composite converter 400 is that the thickness in the incident direction of each converter type is optimized according to its electron-hole generation rate vs. incident distance from the converter surface as shown in Figure 9. Thus, the GaP converter 410 being the thinnest (about 5 micron will suffice), and the Ge converter 450 being the thickest (about 100 micron will suffice). The thickness of the other converters will be in between these thickness extremes.

The fifth element of the composition of the composite converter 400 is that the adjacent converters are not tightly bonded so that their different thermal expansion rates at a temperature above ambient will not distort the disposition of the composite converter 400. This is very important because the different materials used in the converters will have significantly different expansion rates with temperature.

The sixth element of the composition of the composite converter 400 is that the adjacent converters are separated by a thin Si oxide layer forming an asymmetric Fabry-Perot cavity with the neighboring surfaces of the adjacent converters acting as the parallel Fabry-Perot mirrors. On making the oxide thickness appropriately, constructive interference at the wavelength corresponding to the bandgap of the front converter is made to occur so that multiple reflections at that wavelength will take place within the cavity. This situation will maximize the solar beam absorption at this wavelength within the adjacent converters, resulting in the use of thinner converters to compose the composite converter 400. This is important in a better utilization of the expensive crystalline materials on the one hand, and, on the other, in simplifying the implant of converter walls because only thin layers are involved.

The seventh element of the composition of the composite converter 400 is that if more converters of different bandgaps are required to convert the entire solar energy in the ultraviolet to infrared spectrum, more converters may simply be added in parallel to form the composite converter, thus a high thickness in each converter is not necessary.

**Composite Converter Integrated with Radiator**

When the solar beam is concentrated onto the composite converter 400, its temperature will rise causing a reduction in conversion efficiency, and when over a thousand suns is concentrated onto the converter destruction of the converter will occur, unless cooling is provided. To keep the cost of providing cooling down to an acceptable level, our preferred embodiment has a metallic radiator 800 integrated intimately with the composite converter using a metal plate 810 as interface, as shown in Figure 14.

The first element of the radiator 800 is that its radiator fins 820 can be made as numerous and large as required to radiate heat from the converter into space, depending on the temperature of the composite converter needed to be maintained. Typically, a temperature of less than 200°C can be maintained with a compact radiator that is hand-portable for easy installation in the field.

**Active Cooling of Composite Converter**

In another preferred embodiment, the composite converter 400 is used to convert many thousand suns concentrated by a large reflector into many kilowatts of power. In this situation, active cooling using a circulating coolant becomes necessary. This can be done by simply attaching coolant circulating tubes directly onto the radiator 600 shown in Figure 14. For modest active cooling, circulating water will suffice. For high active cooling, circulating liquid nitrogen might be needed, for which the composite converter must be enclosed in a vacuum jacket to prevent water condensation.

**Concentration of Sun**

The most cost effective way of using the composite converter 400 is to integrate it with a large, low-cost plastic Fresnel lens 900, which focuses the solar beam 910 onto the converter 400, as shown in Figure 15. The size of the Fresnel lens used will depend upon the number of suns that the cooled composite converter can handle without being excessively heated to a temperature greater than 200 °C, at which the conversion efficiency starts to decrease rapidly and the integrity of the converter starts to decay. With radiative cooling, such as that shown in Figure 14, a Fresnel lens size that concentrates the solar beam to about 1,000 suns will suffice. But this lens needs to be hardened against ultraviolet radiation. Typically, polycarbonate polymers are preferred over acrylic polymers.

For converting a concentrated beam of more than 1,000 suns, metallic reflectors are preferred, for which active cooling described above will be needed.

**Vertical-wall Multi-junction Converters**

In a preferred embodiment, the multi-junction converter 100 uses vertical walls to form the parallel junctions 110 allowing a uniform generation of electron-hole pairs within the junction region 130, as shown in Figure 5. These vertical walls serve several important purposes:
- Providing a uniform high field within the junction n layer130.
- Providing a free-standing structure for easy assembly into a composite converter.
- Providing a structure that is easily processed on any semiconductor substrates, particularly GaP 310, InGaP 320, GaAs 330, Si 340 and Ge 350.

**Sloped-wall Multi-junction Converters**

In another preferred embodiment, the multi-junction converter 100 uses sloped walls, as shown in Figure 6, to form the multiple junctions advantageously, particularly in making thick junctions in the direction of incidence. These sloped walls serve several important purposes:
- Providing a simple means of implanting the sloped walls to create a thick junction.
- Providing a free-standing structure for easy assembly into a composite converter.
- Providing a structure that is processed at low cost using V-groove etching of a (100 crystal orientation)-Si substrate to make the sloped walls.
- The sloped walls also provide simple support for depositing inter-junction metal contacts, as shown in Figure 6.
- These inter-junction metal contacts also provide an effective means of cooling the multiple junctions of the converter 100 by connecting radiative fins directly onto the junction vicinity.

### Applications of Multi-junction, Nlulti-spectral Converters

An optimized composite converter 400 with a desired spectral characteristic to suit a specific application may be assembled at will with any number and any type of converters 100. For example:
- Used on satellites, a composite converter may be configured with a large reflector to concentrate 10,000 suns onto the converter to generate many kilowatts of power.
- Used on satellites, a composite converter may be assembled with predominantly wide-bandgap converters to convert a concentrated beam rich in the ultraviolet spectrum.
- Used on an aircraft platform, a composite converter may be assembled with only GaAs converters to convert specifically laser energy from a He/Ne laser beamed from elsewhere onto the converter to generate many kilowatts of electricity.
- Used on a remote sensor located in a hard-to-get-to place for remote sensing, a composite converter may be assembled with Ge converters only to convert a Neodynium laser energy beamed onto the composite converter from an aircraft.
- Used on a notebooks, a composite converter with a multiple of 3 different photovoltaic junctions (InGaP, GaAs and Ge) to convert a diffused solar energy into electric power sufficient for notebook use. a.

### Fabrication

For the converters 100 to be cost effective, its fabrication must be straightforward and the processing steps must be simple and low cost. In this invention, the converter fabrication process indeed meet these two requirements, for it involves the processing of over 900 of multi-junction converters 100 on a single 6-inch wafer substrate, as shown in Figure 10, showing that over 900 1 cm x 02cm converter dies can be processed on this wafer by using simple conventional photolithography forming streets 510 and avenues 520 to isolate the converter dies. Different semiconductor wafer substrates (GaP 310, InGaP 320, GaAs 330, Si 340, and Ge 350) are processed in an identical way, so processing a batch of five different wafer types would produce more than 900 converters for each of the five different bandgap types. For those experienced in the field of photolithographic processing, processing a batch of five wafers is just like a drop in a bucket.

In the preferred embodiment, the key processing steps for fabricating vertical-wall converters 100 are as follows:
1. Bond n-type semiconductor wafer to a glass substrate 590 for handling.
2. Lap and polish wafer to a thickness appropriate to its bandgap.
3. Etch wafer into dies onto which to form the converters 100, one of which is shown in Figure 10.
4. Etch trenches 540 in the dies to form material islands 530, as shown in Figure 10.
5. Form the aspect ratio of the trench, trench depth 550 to trench width 560, to a value suitable to make implants 570 and 580 to the walls of the material islands 530.
6. Implant walls of material islands in all the dies.
7. Deposit thin eutectic metal layer 150 covering the implants.
8. Place processed wafer 500 into a rig 600 for fabricating vertical walls, as shown in Figure 11, showing an example of one processed converter 100 inside the rig 600.
9. Seal the processed wafer 500 inside the rig 600 between a metal plate 610 and a glass cover 620 with an O-ring 630.
10. Introduce solvent 640 followed by rinse water into the rig 600 to de-bond processed converters 100 from glass substrate 590.
11. Evacuate solvent and rinse water from rig 600 through the vacuum opening 650.
12. Coalesce the walls of the processed converters 100 together on evacuation forming the converters 100.
13. Heat processed wafer 500 inside rig 600 to about 270 °C to bond adjacent walls to form converters 100.

In another preferred embodiment, the key processing steps in a second method for fabricating vertical-wall converters 100 are as follows:
1. Bond semiconductor wafer to a glass substrate 590 for handling.
2. Lap and polish wafer to a thickness appropriate to its bandgap.
3. Etch wafer into dies onto which to form the converters 100, one of which is shown in Figure 10.
4. Etch trenches 540 in the dies to form material islands 530, as shown in Figure 10.
5. Form the aspect ratio of the trench, trench depth 550 to trench width 560, to a value suitable for making implants 570 and 580 to the walls of the material islands 530.
6. Implant walls of material islands in all the dies.
7. Deposit thin eutectic metal layer 150 covering the implants.
8. Transfer processed wafer 500 onto a pre-stretched elastomer substrate.
9. Release the pre-stretch in the elastomer substrate to coalesce the walls of the converters 100.
10. Heat processed wafer 500 on the elastomer substrate to about 270 °C to bond adjacent walls to form converters 100.
11. Remove converters 100 from elastomer substrate.

In another preferred embodiment, the key processing steps in a third method for fabricating vertical-wall converters 100 are as follows:
1. Bond n-type semiconductor wafer to a glass substrate 590 for handling.
2. Lap and polish wafer to a thickness appropriate to its bandgap.
3. Implant one surface of wafer to an n+ layer 120.
4. Deposit eutectic metal 150 on the implanted n+ layer.
5. Transfer wafer to another glass substrate to expose the other wafer surface.
6. Implant the second surface of wafer to a p+ layer140.
7. Deposit eutectic metal 150 on the implanted p+ layer 140.
8. Etch wafer in the dies of about 1 cm x 0.1 cm.
9. Remove the dies from substrate
10. Stack multiple dies together with the flat eutectic metal surfaces in between dies to form the multi-junction converter 100.
11. Heat processed stacks of dies to about 270 °C to bond adjacent walls to form converters 100.

In another preferred embodiment, the key processing steps in a fourth method for fabricating vertical-wall converters 100 are as follows:
1. Start with a silicon-on-insulator (SOI) wafer with a Si epilayer of 2 micron thick.
2. Grow a lattice-matching SiGe layer by MOCVD on top of the Si epilayer.
3. Grow an n+-type semiconductor layer on top of the SiGe layer by MOCVD.
4. Grow an n-type semiconductor layer on top of the n+-type layer by MOCVD.
5. Grow a p+-type semiconductor layer on top of the n-type layer by MOCVD.
6. Repeat steps 3-5 20 times to grow a stack of 20 n+-n-p+ junctions.
7. Deposit eutectic metal on the 20-junction stack.
8. Delineate the substrate into dies, each containing 20 n+-n-p+ junctions.
9. Transfer substrate to a plastic carrier with the dies close to the plastic carrier.
10. Remove the Si substrate by etching the oxide from the SOI substrate.
11. Remove the Si and SiGe layers by selective etching.
12. Deposit a metal eutectic layer over dies on plastic carrier.
13. Remove excessive eutectic metal from edges of the dies.
14. Remove the dies from plastic carriers.
15. Heat a stack of 20 dies to about 270 °C to bond adjacent walls to form a converter of 1,000 junctions.
16. Repeat steps 1-15 with different semiconductors (e.g., Diamond, AlAs, SiC, GaP, InGaP, GaAs, Si, Ge, InGaAs, and InAs) grown by MOCVD to form different-energy converters.
17. Assemble different-energy converter dies together with wire bonding to form a composite converter.

In yet another preferred embodiment, the key processing steps in a method for fabricating sloped-wall converters 100 are as follows:
1. Bond semiconductor wafer to a glass substrate 700 for handling.
2. Lap and polish wafer to a thickness appropriate to its bandgap.
3. Etch wafer into dies onto which to form the converters 100, one of which is shown in Figure 13.
4. Etch V-grooved trenches 720 in the dies to form material islands 710, as shown in Figure 13.
5. Form the aspect ratio of the trench, trench depth 730 to trench width 740, to a value suitable to make implants 760 and 770 to the walls of the material islands 710.
6. Implant walls of material islands in all the dies.
7. Deposit thin eutectic metal layer 150 covering the implants to form the converter 100 as shown in Figure 6.
8. Electrode plate and fill in the V-grooved trenches with a thermally conducting metal to radiate heat away from converter 100.
9. Remove converters 100 from substrate 700.

### Object Identfication Numbers

The following table identifies the objects labeled in the included drawings

**Table 1**

| **Multi-junction, Multi-spectral Solar-energy Converter** | |
|---|---|
| 100 | **Multi-junction Converter** |
| | In the text, the terms converter, multi-junction converter, vertical-wall converter, and sloped-wall converter are used somewhat interchangeable. When discussing a general solar cell, converter is used; when the converter has one junction or multiple junctions, converter is used; when discussing a multi-junction converter made with vertical walls, vertical-wall converter is used; and when a multi-junction is made with sloped walls, sloped-wall converter is used. |
| 110 | Photovoltaic junction, junction or junction with vertical walls |
| 120 | n+-doped layer |
| 130 | n-doped junction layer |
| 140 | p+-doped layer |
| 150 | Thin metal or eutectic metal layer |
| 160 | Photovoltaic junction with sloped walls |
| | |
| **200** | **Energy Band of Junction Receptive to Solar Beam** |
| 210 | Incident solar energy |
| 220 | Electron in junction generated by solar energy |
| 230 | Hole in junction generated by solar energy |
| 240 | Fermi level of energy band |
| 250 | Output current generated by solar energy |
| 260 | Energy band diagram of multi-junction converter |
| | |
| **300** | **Solar Spectrum** |
| 310 | Spectral response of GaP semiconductor or GaP substrate or GaP converter |
| 320 | Spectral response of InGaP semiconductor or InGaP substrate or InGaP converter |
| 330 | Spectral response of GaAs semiconductor or GaAs substrate or GaAs converter |
| 340 | Spectral response of Si semiconductor or Si substrate or Si converter |
| 350 | Spectral response of Ge semiconductor or Ge substrate or Ge converter |
| | |
| **400** | **Composite Converter** |
| 410 | GaP converter |
| 420 | InGaP converter |
| 430 | GaAs converter |
| 440 | Si converter |
| 450 | Ge converter |
| 460 | Electrical wire connection between converters |
| 470 | External load |
| | |
| **500** | **Processed Wafer** |
| 510 | Etched street |
| 520 | Etched avenue |
| 530 | Vertical-wall Material island |
| 540 | Etched vertical-wall trench |
| 550 | Depth of etched vertical-wall trench |
| 560 | Width of etched vertical wall trench |
| 570 | First implant on vertical wall |
| 580 | Second implant on vertical wall |
| 590 | Glass substrate |
| | |
| **600** | **Rig for Fabrication** |
| 610 | Metal plate |
| 620 | Glass cover plate |
| 630 | O-ring |
| 640 | Solvent or solution of rinsing water |
| 650 | Vacuum outlet |
| | |
| | **Sloped-wall Converter Fabrication** |
| 700 | Glass substrate for sloped-wall converter |
| 710 | Sloped-wall material island |
| 720 | Etched sloped-wall trench |
| 730 | Depth of etched sloped-wall trench |
| 740 | Width of etched sloped-wall trench |
| 750 | Width of top of sloped-wall material island |
| 760 | First implant of sloped wall |
| 770 | Second implant of sloped wall |
| | |
| **800** | **Radiator** |
| 810 | Interface metal plate |
| 820 | Radiator fin |
| | |
| **900** | **Fresnel Lens** |
| 910 | Solar beam |
| 920 | Concentrated or focused solar beam |

**Citations**

- US 7,071,407 (FATERNI, ET AL.) 04.07.2006
- US 5,405,453 (HO, ET AL.) 11.04.1995
- US 7,126,052 (FETZER, ET AL.) 24.10.2006
- US 7,122,734 (FETZER, ET AL.) 17.10.2006
- US 6,252,287 (KURTZ, ET AL.) 26.06.2001
- US4,335,503 (EVANS, JR., ET AL.) 22.06.1982
- US 4,295,002 (CHAPPELL, ET AL.) 13.10.1981
- US 4,131,984 (KAPLOW, ET AL.) 02.01.1979
- US 3,969,746 (KENDALL, ET AL.) 13.07.1976
- US 5,246,506 (ARYA, ET AL.) 21.09.1993
- US 4,271,328 (HAMAKAWA, ET AL.) 02.06.1981
- US 6,372,980 (FREUNDLICH) 16.04.2002
- US 6,340,788 (KING, ET AL.) 22.01.2002
- US 6,174,296 (WANG) 16.01.2001
- US 4,376,872 (EVANS, ET AL.) 15.03.1983
- MCCONNELL, R., et al. "Next-Generation Photovoltaic Technologies in the United States". 19th European PVSolarEnergy Conference and Exhibition, Paris, France. JUNE 2004, p.1.

## Claims

1. A solar converter for converting incoming solar beam to electricity via at least two adjacent layers of solar cells, wherein each layer comprises a at least one junction, and wherein at least one layer is bonded to at least one other layer without requiring that the lattices of adjacent layers match.

2. A converter as in claim 1 wherein at least one of said layers comprises at least one junction of a first type specific to at least one energy bandgap

3. A converter as in claim 1 wherein at least one of said layers comprises junctions of a first type specific to at least one first energy bandgap, and junctions of at least one other type specific to an energy bandgap different than said first type.

4. A converter as in claim 1 wherein each layer comprises at least 10 individual junctions.

5. A converter as in claim 1 wherein each layer comprises at least 100 individual junctions.

6. A converter as in claim 1 wherein said converter comprises at least 10 multi-junction layers.

7. A converter as in claim 1 wherein said converter comprises at least 100 multi-junction layers.

8. A converter as in claim 1 wherein the density of junctions per unit of area is at least 1000 junctions per cm².

9. A converter as in claim 1 wherein said junctions are disposed parallel to an incident solar beam, whereby each of said junctions is illuminated by an approximately equal amount of solar energy from said incoming solar beam.

10. A converter as in claim 1 wherein said junctions are connected electrically in series.

11. A converter as in claim 1 wherein each layer is individually processed/created independently from any other layer.

12. A converter as in claim 1 wherein a first layer and at least one other layer are processed/created from different substrates.

13. A converter as in claim 1 wherein said junctions are created via semiconductor fabrication techniques.

14. A converter as in claim 1 wherein said junctions are created via organic growth.

15. A solar converter as in claim 1 wherein a first layer captures energies of at least one bandgap while allowing energies of at least one lower bandgap to pass through to at least one layer beneath it.

16. A solar converter as in claim 15 wherein said at least one bandgap is at least 1.8 eV.

17. A solar converter as in claim 15 wherein said at least one bandgap is at least 1.4 eV.

18. A solar converter as in claim 15 wherein said at least one bandgap is at least 1.1 eV.

19. A solar converter as in claim 15 wherein said at least one bandgap is at least 0.6 eV.

20. A converter as in claim 1 wherein each of said junctions comprises a first wall doped with n+-type carriers and a second wall doped with p+-type carriers.

21. A converter as in claim 20 wherein the region sandwiched by said walls is doped with n-type carriers.

22. A converter as in claim 20 wherein the region sandwiched by said walls is doped with p+-type carriers.

23. A converter as in claim 20 wherein said first wall and said second wall are disposed perpendicular to the incoming solar beam.

24. A converter as in claim 20 wherein said first wall and said second wall are disposed perpendicular to the nominal plane of the junction's layer.

25. A converter as in claim 1 wherein said junction comprises a width smaller than the diffusion length of minority carriers generated in said junction by said incoming solar beam.

26. A converter as in claim 25 wherein said width comprises a high electric field extending across said width.

27. A converter as in claim 1 wherein a first junction and at least one other junction are of the same width.

28. A converter as in claim 1 wherein a first junction and at least one other junction are of different widths.

29. A converter as in claim 1 wherein a first layer and at least one other layer are of the same thickness.

30. A converter as in claim 1 wherein a first layer and at least one other layer are of different thicknesses.

31. A composite converter comprised of at least two converters as in claim 1, wherein said at least two converters are stacked such that at least two bandgaps are simultaneously absorbed and converted.

32. A composite converter as in claim 31 wherein each converter comprises a junction width optimized for at least one energy bandgap.

33. A composite converter as in claim 31 wherein each bandgap is absorbed and converted in its own discrete converter.

34. A composite converter as in claim 31 wherein said at least two converters are aligned front-most to rear-most in order from highest to lowest bandgap, and wherein the solar beam that is not converted in the front-most converters(s) traverses through to be converted in subsequent converter(s) without interference.

35. A composite converter as in claim 31 wherein all of said converters are connected electrically in series.

36. A composite converter as in claim 31 wherein said at least two converters are loosely bonded to their adjacent neighbors, whereby their different thermal expansion rates will not distort said disposition of said composite converter.

37. A composite converter as in claim 31 wherein said at least two converters are separated by a Fabry-Perot cavity, and wherein said solar beam undergoes multiple reflections in a specific spectral wavelength.

38. A composite converter as in claim 37, wherein said Fabry-Perot cavity comprises a cavity spacing determined by a layer of silicon oxide.

39. A composite converter as in claim 37, wherein said layer of silicon oxide comprises a thickness that is varied to maximize the absorption of at least one energy bandgap within each converter.

40. A composite converter as in claim 31 further comprising at least one radiator integrated with said composite converter, whereby said composite converter, when illuminated by multiple suns, is kept at a temperature below 250°C.

41. A composite converter as in claim 40 wherein said at least one radiator comprises passive cooling.

42. A composite converter as in claim 40 wherein said at least one radiator comprises active cooling.

43. A composite converter as in claim 1 further comprising a Fresnel lens which focuses said solar beam, concentrating it to a strength equal to a plurality of suns prior to the solar beam being converted by the converter.
